# EUROPEAN PATENT APPLICATION

(11) **EP 4 350 981 A1**
(43) Date of publication of application: **10.04.2024**
(21) Application number: 22200372.5
(22) Date of filing: 07.10.2022
(51) Int. Cl.: H02S 20/25, H01L 31/042, H02S 40/34

(54) **PV PANEL WITH INJECTION MOULDED SUPPORT STRUCTURE FOR INSTALLATION ON A BUILDING**

(71) Applicant: Sono Motors GmbH, 80935 München (DE)
(72) Inventor: HAHN, Laurin, 81373 München (DE)
(74) Representative: Qip Patentanwälte Dr. Kuehn & Partner mbB

(57) **Abstract**

A photovoltaic panel (1) for an installation on a building is described. The panel includes a photovoltaic label (3) and a support structure (17). The photovoltaic label comprises a front side polymeric lamination foil (5), a rear side polymeric lamination foil (7) and a solar cell arrangement (9) including multiple solar cells (11) interposed between the front and rear side lamination foils. The support structure supports and stabilized the photovoltaic label. The support structure comprises a mouldable polymer covering at least a front surface (19) of the photovoltaic label (3) and may preferably be made using injection moulding. The support structure further comprises a fixation arrangement (23) including multiple attachment structures (25) configured for being attached to a carrier structure (27) provided at a surface of the building. The support structure is configured such that support structures of neighbouring photovoltaic panels are attachable to the building's carrier structure such that the neighbouring photovoltaic panels overlap each other in a shingling manner.

## Description

### FIELD OF THE INVENTION

The present invention relates to a photovoltaic panel which is specifically configured for being installed on a building.

### TECHNICAL BACKGROUND

Photovoltaic panels are used to directly convert light into electricity. In the following, the term "photovoltaic" may be abbreviated by "PV". PV cells may also be referred to as solar cells.

PV panels may be installed on a building such as to cover at least portions of a roof or of a facade. Conventionally, most PV panels are generally prepared as separate components which are then installed on the building. For example, PV panels are installed on top of the roof of the building, wherein such roof is for example covered with conventional tiles in order to protect the building e.g. against weather influences such as rain, snow, storm, etc. Therein, a PV panel typically comprises a multitude of solar cells which are laminated between a front side glass sheet and a back sheet, all of the stack being supported by a frame. Each such PV panel typically has a substantial size of e.g. more than 0.5 m² and the solar cells comprised in such PV panel may provide a peak power of for example more than 100 Wp. Such conventional PV panels may be installed on the building using for example specific installation hooks for attaching the PV panel to a building's a carrier structure such as rafters of a roof construction. A plurality of PV panels may then be electrically interconnected to form a PV array and the PV array may then be connected to e.g. a converter. The converter may transform the electricity provided by the PV panels in order to supply this energy to the building or to a grid. Typically, the converter comprises an MCU (Microcontroller Unit) for implementing various functionalities such as an MPPT functionality (Maximum Power Point Tracking).

However, installing conventional PV panels on a building may have various disadvantages. For example, such conventional PV panels are generally heavy and may therefore overload a statics of the building, such that PV installation is prevented on many roofs. Furthermore, conventional PV panels may negatively influence a visual appearance of a building and many people interpret such PV panels as deteriorating an aesthetics of e.g. a roof or a facade. Additionally, as conventional PV panels generally have a rectangular shape and a flat structure, only portions of a building having a regular and planar surface, such as portions of simple roofs, may serve for a PV panel installation, whereas portions of a more sophisticated geometry, i.e. with a non-square contour and/or a curved surface, are hardly suitable for conventional PV panel installation.

As an alternative, so-called PV tiles have been developed. Such PV tiles have a form and/or look similar to conventional tiles or shingles covering many roofs. Accordingly, PV tiles may be used for covering roofs while allowing both, electricity generation as well as traditional appearance and aesthetics of the roof. One or a few solar cells are generally attached to or integrated into such PV tile. While the PV tiles may be mechanically installed on a building in a similar manner as conventional non-PV tiles, the PV tiles also have to be electrically interconnected in order to form an array which may then be connected e.g. to a converter. As each single PV tile typically has an area of less than 0.1 m², a large quantity of PV tiles (i.e. e.g. more than 1000 PV tiles) is generally required to cover an entire roof or a significant portion thereof, in order to provide a PV array having a peak power of e.g. several kilowatts. However, all these PV tiles not only have to be mechanically installed but also have to be electrically interconnected, thereby significantly increasing efforts, time and costs for installing a PV-tile-based photovoltaic array. Furthermore, the PV tiles may be relatively heavy as they generally comprise a support structure made of concrete or clay and, additionally, they often comprise a glass plate covering the solar cells, such that covering an entire roof with such PV tiles may pose problems to the statics of the building. As an additional aspect, each of the multiple PV tiles in a PV array generally requires its own electrical connectors such as a connection box in order to enable interconnection with neighbouring PV tiles, thereby adding significant costs to the entire PV array. Furthermore, due to the large multiplicity of PV tiles, coordinating and/or supervising an operation of the electricity generation in the PV array is a complex task and, particularly, maximum power point tracking (MPPT) may require a sophisticated controller, thereby increasing the overall cost of the PV system.

### SUMMARY OF THE INVENTION AND OF EMBODIMENTS

It may be an object to provide a PV panel which is adapted for being installed on a building and which may solve or reduce at least some of the above mentioned deficiencies. Particularly, there may be a need for a PV panel which may enable efficient electricity generation, low-cost, high robustness, reliable operability, simple and cost efficient manufacturability and/or easy installation.

Such objects may be met with the subject-matter of the independent claims. Advantageous embodiments are defined in the dependent claims and described in the following specification and visualised in the associated figures.

According to an aspect of the present invention, a photovoltaic panel for an installation on a building is described, the panel including a photovoltaic label and a support structure. The photovoltaic label comprises a front side polymeric lamination foil, a rear side polymeric lamination foil and a solar cell arrangement including multiple solar cells interposed between the front and rear side lamination foils. Additionally, the photovoltaic label may optionally comprise a front side polymeric stabilisation foil and/or a rear side polymeric stabilisation foil for providing the PV panel with an increased stability and rigidity. The support structure is configured for supporting the photovoltaic label, wherein the support structure comprises or consists of a mouldable polymer covering at least a front surface of the photovoltaic label. Optionally, the support layer may further cover a rear surface of the photovoltaic label such as to tightly enclose the PV label, i.e. the PV label may be (integrally) embedded in the polymer of the support structure. The support structure comprises a fixation arrangement including multiple attachment structures configured for being attached to a carrier structure provided at a surface of the building. The support structure is configured such that support structures of neighbouring photovoltaic panels are attachable to the building's carrier structure such that the neighbouring photovoltaic panels overlap each other in a shingling manner.

Briefly summarised and without limiting the scope of the invention, basic ideas underlying embodiments of the invention and associated possible advantages may be roughly described as follows: the applicant developed a technology with which high-efficiency wafer-based solar cells may be embedded in or at a support structure made of a polymer. Therein, the support structure may be produced using injection moulding technology which is specifically adapted such as to include a solar cell arrangement within a moulded polymer structure. While this technology has originally been developed for producing vehicle-integrated photovoltaics (ViPV) such as vehicle body parts including PV electricity generating capacity, the principles of such technology may also be used and adapted for producing building-integrated photovoltaics (BiPV), i.e. photovoltaic panels for an installation on a building. Particularly, while it is possible to use such technology for producing PV panels which may be installed on a building as separate components (similar to conventional PV panels), it has been found that, using the technology, specific panels may be manufactured which are specifically adapted for an installation directly on a building's carrier structure (i.e. e.g. directly on rafters of a roof), similarly to conventional PV tiles. Such approach may allow for various benefits such as, inter alia:
- reduced material requirements, as no separate tiles, on the one hand, and PV panels, on the other hand, have to be provided but both functions may be integrated in a PV panel also providing conventional tile's tasks such as wind and weather protection,
- low weight and high reliability, due to the use of lightweight and robust polymer material instead of heavy and/or brittle concrete, clay and/or glass components,
- low production costs, due to the possible use of industrial-scale injection moulding techniques,
- sufficient weather resistance, due to the use of resistant polymer materials,
- etc.

Furthermore, it has been found that the deficiencies of conventional PV tiles may be overcome by using the applicant's developed technology for producing PV panels with a sufficiently large area such as to comprise multiple solar cells (e.g. more than 10, preferably more than 50 solar cells), thereby allowing, inter-alia, easy and fast installation, reduced wiring requirements, simplified operation such as MPPT, etc.

In the following, possible features of embodiments of the invention and associated possible advantages will be described in more detail.

As indicated above, approaches have been presented by the applicant in which PV cells are provided at a body of a car for generating electricity to be supplied to the car. Such electricity may be used for example for charging batteries of an electric car. For example, it has been proposed e.g. in an earlier patent application WO 2020/187792 (title: "Method for manufacturing of a photovoltaic module") to integrate a solar cell arrangement into a moulded layer formed by injection moulding. Therein, the solar cell arrangement is interposed between polymeric foils, thereby forming a so-called photovoltaic label which may be securely handled and in which the solar cells are for example protected against excessive mechanical stress during an injection moulding procedure. Another approach for a car body panel comprising an integrated solar cell arrangement has been proposed by the present applicant in earlier patent application WO 2022/122507 (title "Car body panel including a solar cell arrangement and method for producing same"). In each of these prior art approaches, the car body panel including the solar cell arrangement may be regarded as a photovoltaic module having a non-planar shape. Possible features and characteristics of such approaches of car body panels and approaches for fabricating a car body panel including a photovoltaic module have been described by the applicant in the above mentioned patent applications as well as in further prior patent applications such as WO 2021/260021 (title: "Method for fabricating a photovoltaic module including laser cutting of a photovoltaic label"), WO 2021/260024 (title: "Method for fabricating a curved photovoltaic module including adapted positioning of photovoltaic cells"), DE 10 2022 108 014 (title: "Method for fabricating a photovoltaic module using in-mould labelling with specific temperature management") and DE 10 2022 101 935 (title: "Method for producing a photovoltaic panel such as a PV integrated vehicle body panel using a thermosetting polymer"). While the technology was discussed in the previous patent applications with a focus on manufacturing the vehicle-integrated photovoltaics, such technology may also be applied or adapted for producing building-integrated photovoltaics as discussed herein. Accordingly, features and characteristics of such approaches may also apply to the photovoltaic panel for installation on a building described herein and the content of the earlier patent applications shall be incorporated in its entirety herein by reference.

Furthermore, the applicant files another patent application concurrently with the present application, this other application having the title "Photovoltaic panel with integrated functional component for installation on a building and method of manufacturing a photovoltaic panel". Features and characteristics of approaches disclosed in the other application may also apply to the photovoltaic panel for installation on a building described herein and the content of the other patent application shall be incorporated in its entirety herein by reference.

The approach proposed herein is particularly suitable for a building integrated PV panel (BiPV) or a building applied PV panel (BaPV) comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 26%) and a high reliability. Furthermore, well established industrial processes exist for their fabrication. Such PV cells typically have lateral dimensions of between 50×50 mm² and 300×300 mm², mostly between 150×150 mm² and 200×200 mm², with a square shape, a rectangular shape, a round shape, a semi-round shape or any other shape. Furthermore, such PV cells generally have a thickness of more than 50 µm, typically between 100 µm and 300 µm.

Having such thickness, the PV cells are relatively rigid, i.e. they may generally not be bent into small bending radii of e.g. less than their lateral dimensions. Generally, it may be assumed that, depending on a cell size, bending radii of less than 80 cm, less than 90 cm or less than 100 cm should be avoided.

Each PV cell comprises electric contacts. One type of silicon solar cells which is particularly well suited for being used in the PV panels described herein are back contact solar cells (also referred to as IBC (interdigitated back contact) solar cells) having electric contacts for both polarities on their rear side. The electric contacts of neighbouring PV cells may be interconnected via electrical connections such that these PV cells may be electrically connected in series, in parallel or in any combination of series and parallel connections. The electrical connections may be provided by one or more electrically conducting ribbons and/or one or more copper solderings between two adjacent photovoltaic cells, preferably between each two adjacent photovoltaic cells of a respective string. As a beneficial option, back contact solar cells may be interconnected using metal patterns provided on a sheet substrate. A plurality of interconnected PV cells forms part of a solar cell arrangement, sometimes also referred to as solar cell string. The solar cell arrangement may further comprise additional components such as external contacts via which the solar cell arrangement may be connected to an external electric circuit, such external contacts sometimes being referred to as forming part of a junction box. Furthermore, the solar cell arrangement may comprise for example bypass diodes or other electric components. Additionally, one or more release loops for releasing mechanical tensions may be included in the solar cell arrangement.

For forming a PV label, the solar cell arrangement is generally comprised in an encapsulation into which the solar cells, the electrical interconnections and possibly other components are embedded. Typically, the encapsulation comprises or consists of a thermoplastic polymer such as EVA (Ethylene Vinyl Acetate) or POE (Polyolefin Elastomer). The encapsulation is composed of a front side polymeric lamination foil and a rear side polymeric lamination foil enclosing the plurality of solar cells from opposite sides. The lamination foils may also be referred to as encapsulation foils. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

As the solar cell arrangement in its encapsulation is generally very fragile, the solar cell arrangement including the solar cells, the electric connections and the encapsulation may be reinforced by one or more stabilisation foils for forming and reinforcing the PV label. Preferably, a front side polymeric stabilisation foil and a rear side polymeric stabilisation foil may enclose the interposed solar cell arrangement and may form a substrate and a superstrate, respectively, prior to reinforcing the PV label by moulding the support structure. In specific embodiments, the PV label may not necessarily comprise each of the front and rear side polymeric stabilisation foils. The one or more polymeric stabilisation foils may have a thickness of typically between 250µm and 2500µm. Each of the foils may adjoin and/or cover a part or an entirety of one of opposing surfaces of all of the PV cells. The polymeric stabilisation foils may be made with various polymeric materials such as, polycarbonate (PC), polyethylenterephthalat (PET), polyamide (PA), polyetheretherketone (PEEK), Acrylonitrile butadiene styrene (ABS), Polymethyl methacrylate) (PMMA), Polyvinylchlorid (PVC) or a mix of them. At least the front side stabilisation foil as well as the front side lamination foil shall consist of an optically translucent or transparent material. Particularly, a material forming the stabilisation foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fibre reinforced or carbon fibre reinforced plastics may be included between the polymeric foils.

Particularly, the front side stabilisation polymeric foil, the rear side stabilisation polymeric foil and the PV cells may be joined together by an application of heat and/or a lamination process. In other words, after having arranged e.g. the rear side polymeric stabilisation foil, the solar cell arrangement with its encapsulation and finally the front side polymeric stabilisation foil on top of each other in a lose manner, these stacked layers may be interconnected by mechanically joining with each other. Such joining may be induced for example by applying sufficient heat to the stack such that the polymeric material of the polymeric foils becomes viscous and/or sticky. Accordingly, upon such temporary application of heat, the polymeric stabilisation foils may mechanically interconnect with each other and/or with the interposed solar cell arrangement.

Thus, the front and rear side polymeric stabilisation foils and the solar cell arrangement are joined in a lamination procedure. The lamination procedure may be integral with the lamination procedure used for forming the encapsulation embedding the PV cells, i.e. both the front and rear side polymeric stabilisation foils as well as the front and rear side polymeric encapsulation foils may be glassified or partially molten within a single lamination step. Alternatively, two separate lamination steps may be performed, i.e., first, the solar cell arrangement is laminated with the encapsulation foils enclosing the PV cells and, then, the PV label is laminated with the stabilisation foils enclosing the solar cell arrangement in between. As a result of such lamination procedure, the front and rear side polymeric foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

The entire PV label may have a thickness in a range of between 0.5 mm to 10 mm, typically between 0.5 mm to 5 mm or between 1 mm and 3 mm. Lateral dimensions of the PV label may range from about 0.1 m to 2 m, typically from 0.2 m to 1 m. The PV label may be flexible and bendable and may be formed into an arbitrary contour being adapted to a shape of the intended PV panel. Therein, the solar cells comprised in the PV panel cover a substantial portion, i.e. for example more than 50%, preferably more than 70% or even more than 90%, of an outer surface of the PV panel.

The PV label is generally flexible, bendable and/or, at least in some applications, not sufficiently self-supporting. Accordingly, for forming a self-supporting PV panel, the PV label generally has to be reinforced by a support structure. Such support structure typically has a higher mechanical stability than the PV label. Such higher mechanical stability may result, inter-alia, from larger geometrical dimensions such as a larger thickness compared to the thickness of the PV label and/or higher stiffness due to material properties of the polymer used. The support structure and the PV label are generally mechanically interconnected such that forces acting onto the PV label may be transmitted to the support structure and vice versa.

According to the approach described herein, the support structure shall be prepared with a mouldable polymer, particularly a thermoplastic or thermosetting polymer. Particularly, the support structure may mainly consist (i.e. consist to more than 50%, more than 70% or even more than 90%, 95% or 98%) or completely consist of polymer material. Such polymer material may be processed such that, during being applied to the PV label, it has a sufficiently low viscosity such as to enable spreading the polymer along a surface of the PV label without exerting excessive forces onto the PV label.

Particularly, according to an embodiment, the support structure may be made by injection moulding the mouldable polymer material together with the PV label. As described in more detail for example in the applicant's prior applications (see e.g. DE 10 2022 101 935 A1), various types of thermoplastic or thermosetting polymers may be used for moulding the support structure. The polymer may be provided as a single component or may be a mixture of two or more components. At least one of these components may be a liquid having a low viscosity. For example, the viscosity at room temperature (25°C) may be below 1000 mPa^{∗}s, preferably below 300 mPa^{∗}s or even below 150 mPa^{∗}s. In a manufacturing process, the mouldable polymer is applied to the PV label. Particularly, for preparing the PV panel described herein, the mouldable polymeric is applied with a sufficient thickness such as to cover the front surface of the PV label, i.e. the surface which is directed towards light being incident onto the PV label in normal operation. The mouldable polymer may be spread along the entire front surface of the PV label. Additionally, the mouldable polymer may also be applied onto partial areas or an entire area of a rear surface of the PV label of this rear surface. Preferably, the mouldable polymer may be applied such that the entire PV label is embedded in the polymer, i.e. the support structure made by the polymer integrally and tightly encloses the PV label. For forming the support structure, the mouldable polymer is applied onto the PV label in a vicious condition and is then formed into an intended shape of the panel by using a mould. In other words, in order to define a final shape of the support structure and of the entire panel, a mould is provided, the mould having a surface with a shape being complementary to the intended shape of the support structure. The mould may have a cavity, an inner surface of such cavity corresponding to the intended shape of the support structure. Accordingly, upon arranging the PV label in the cavity and filling the remaining volume of the cavity with the polymer, the support structure supporting the PV label may be prepared. Alternatively, the mould may have a surface with the intended shape and may be pressed onto a mouldable polymer mass which has been applied to the PV label in a preceding processing step, thereby forming and shaping the polymer. Upon the polymer being formed and shaped in such manner, it may then solidify at least to a degree in which it is sufficiently stable and preferably self-supporting before being removed from the mould.

For preparing the PV panel described herein and adapting it for its operation on a building, the support structure is provided such that it covers at least the front surface of the PV label. In other words, during a manufacturing procedure, the mouldable polymer forming the support structure is applied such that it at least covers the PV label at the surface which, during later operation, is mainly directed towards the sun and is also exposed to external influences such as weather influences. Accordingly, a layer formed by the polymer and covering the PV label's front side should be made such as to resist such external influences.

For example, according to an embodiment, the support structure may cover the front surface of the PV label with a polymer layer having a thickness of at least 2 mm, preferably at least 3 mm, at least 4 mm or at least 5 mm. Particularly, a thickness of the polymer layer may be adapted such as to provide sufficient hail resistance to the PV panel. Therein, it may be advantageous that polymers, upon being solidified, may provide a high mechanical strength and rigidity to the support structure while also providing a very substantial notch-rupture strength. Particularly, while being generally of lower weight and/or being producible at substantially lower costs, a polymer layer formed in the support structure for covering the PV label may provide for a same or even better weather and hail resistance as compared to glass cover sheets conventionally used in PV panels. In order to even further increase the PV panels protection capacity, specific types of polymer may be used for preparing the support structure or for preparing an additional protection layer e.g. covering the support structure at its exposed outer surface, thereby further improving characteristics of the PV panels such as its scratch resistance, UV resistance, optical transmission, resistance against deposition of dirt, general optical appearance, etc.

Additionally to its function of protecting the PV label and particularly the solar cells comprised therein, the support structure shall also be configured for enabling a fixation of the PV panel at the building. For such purpose, the support structure comprises a fixation arrangement including multiple attachments structures. These attachments structures are specifically configured for being attached to a carrier structure which is provided at a surface of the building. For example, such carrier structure may be part of a roof construction including multiple roof beams and rafters. While, in conventional roofs, such carrier structure (i.e. for example the rafters) is used for holding for example conventional tiles, according to the approach proposed herein, the building's carrier structure shall be used for directly carrying the PV panels without a need for conventional tiles being interposed between the building's carrier structure and the PV panels. Accordingly, the support structure of the PV panel shall include attachments structures via which the PV panel may be directly fixed to the carrier structure of the building. For example, attachments structures may be implemented as elongate protrusions which extend from a portion of the support structure embedding the PV label towards a location at which the PV panel may be fixed to the building's carrier structure. Such protrusions may extend in a direction being orthogonal, being diagonal or being parallel to a plane in which the PV label extends.

Particularly, according to an embodiment, the attachments structures may comprise or even mainly or completely consist of a mouldable polymer and may integrally protrude from other portions of the support structure. In other words, the attachment structures may be no separate components to be separately manufactured and then attached to the support structure. Instead, the attachment structures may themselves be made of a mouldable polymer which may be the same polymer as used for other portions of the support structure or which may be compatible with such polymer (i.e. which may for example be joined with such polymeric in a common moulding procedure). Accordingly, the attachment structures may be formed integrally together with the other portions of the support structure. Particularly, the attachment structures may be formed in a same injection moulding process as used for forming the rest of the support structure including its polymer layer covering or enclosing the PV label. Thus, the entire PV panel including the support structure with its attachment structures may preferably be produced using a single moulding procedure.

As one of its characteristics, the PV panel and particularly its support structure and its included attachment structures are specifically configured such that the support structures of neighbouring PV panels may be attached to the building's carrier structure such that the neighbouring PV panels overlap each other in a shingling manner. In other words, both, the lateral extension of the support structure (i.e. its optionally generally curved or locally curved geometry) as well as a geometry of the attachment structures shall be adapted such that adjacent panels overlap at least at portions of their outer circumference. Particularly, neighbouring panels shall at least slightly overlap each other at least at one of their edges where the panels abut to each other. Due to such overlapping and shingling arrangement of neighbouring PV panels, the PV panels may provide for functionalities which, conventionally, are provided by other building components such as shingling tiles covering a roof. Accordingly, the PV panels may provide for example for weather protection including, inter-alia, preventing rain water from leaking through gaps between neighbouring panels.

For such purpose, the PV panels and particularly, its support structure may be specifically formed with regards to their geometry such that, when a PV panel is installed next to another PV panel at the building's a carrier structure, at least portions at or close to an edge or a circumference of the PV panel may overlap with portions of the neighbouring PV panel in a shingling manner. Such overlapping portions may be realised by the support structure having a curved geometry and/or having laterally protruding undercut portions and/or overcut portions forming sealing structures. Both, the curved geometry and the laterally protruding portions may be easily realised due to the fact that the support structure is made with a polymer such that complex geometries may be realised using for example injection moulding techniques.

According to an embodiment, the panel may have a substantial size such as to comprise an area of at least 0.3 m², preferably at least 0.5 m² or even at least 1 m². Additionally or alternatively, the solar cell arrangement may have a peak power capacity of at least 100 Wp, preferably at least 200 Wp or at least 300 Wp. On the one hand, the PV panel having such large area and/or peak power capacity may simplify an installation procedure. Particularly, instead of e.g. having to install a large number of relatively small PV tiles, only a small number of large PV panels may have to be installed at the building's carrier structure. Thereby, efforts for mechanically fixing PV array components to the building as well as efforts for electrically interconnecting such PV array components may be significantly reduced. On the other hand, PV panels having a large size and/or high peak power capacity may be easily produced based on their support structure being made from polymer. Furthermore, such large size PV panels may be produced with a relatively low weight such that even panels having a size as large as or larger than conventional PV panels may be handled and installed e.g. manually. Furthermore, as the PV panel proposed herein has a similar peak power capacity similar to those of conventional PV panels, it may easily be operated using conventional cooperating components such as conventional converters, MPPT controllers, etc.

According to an embodiment, the support structure of the PV panel is provided with a non-flat surface geometry. In other words, at least portions of the surface of the support structure are curved and/or include steps. Such non-flat surface geometry may, on the one hand, provide for the desired ability for a shingling arrangement of neighbouring PV panels as, for example, portions of the support structure may be bent such as to locally overlap portions of the neighbouring PV panel. On the other hand, the non-flat surface geometry may be configured such as to produce an intended visual appearance of the PV panel. In contrast to conventional PV panels for which the surface geometry is generally flat as it is predetermined by the use of a flat glass front sheet, the polymer-based support structure of the PV panel presented herein may be provided with any arbitrary surface geometry.

For example, according to an embodiment, the support structure may be provided with a surface geometry imitating multiple tiles. I.e. the surface geometry of the support structure may be configured such as to look like being composed of multiple virtual tiles which may be arranged in an overlaying or shingling manner. Thereby, a roof of a building covered with the PV panels proposed herein may have a visual appearance similar to a conventional roof being covered by multiple tiles or shingles. In an overall appearance, the virtual tiles may be arranged in multiple horizontal rows and/or multiple vertical columns. Therein, neighbouring virtual tiles overlap or appear to overlap at least at one of their edges. Accordingly, even though the roof may have a conventional aesthetic, it may be provided with a PV functionality for producing electricity.

According to an embodiment, the support structure may be provided with a surface geometry being composed of multiple identical unit cells. The unit cells may be arranged along the surface of the PV panel in a repetitive pattern. For example, unit cells may be arranged in one or multiple rows and one or multiple columns. The unit cells may have dimensions similar to those of conventional tiles. For example, a unit cell may have a length and/or width of between 10 cm and 50 cm, preferably between 15 cm and 30 cm. The unit cells may have any arbitrary shape suitable for covering a surface in gap-free manner, i.e. for example a square shape, a rectangular shape, a hexagonal shape, etc. Neighbouring unit cells may be optically separated from each other by delimiting structures such as a protrusion line, a recess line, etc. Providing the support structure with a pattern of unit cells at its surface may improve a visual appearance and/or a functionality of a roof covered with the PV panels described herein.

According to an embodiment, each unit cell may have a curved surface and/or a curved contour. For example, the unit cells may be shaped such that their curved surfaces resemble or imitate the surfaces of conventional tiles being arranged in a shingling manner. The surface of the unit cells may be curved in one dimension or in two dimensions. Further to or alternatively to their curved surface, the unit cells may have a curved contour, i.e. the unit cells may have non-linear edges. For example, the unit cells may have a partially rounded contour. As a result, additional to a pleasant visual appearance, the surface and/or contour of the unit cells may be configured for providing functional benefits such as an increased mechanical loadability, a generation of channels e.g. for draining rainwater, etc.

According to an embodiment, neighbouring unit cells may extend along planes being spaced from each other by a distance referred to herein as tiling distance. In other words, the PV panel may be divided into multiple unit cells wherein the unit cells do not extend all in a same plane but at least one or some of the unit cells extend in a plane which is different from the extension plane of the unit cells. Therein, an extension plane of a unit cell may correspond to a plane in which an exposed front side surface of the virtual tile represented by the unit cell extends or to a geometric middle plane of the support structure in the area of the unit cell. Alternatively, the extension plane of the unit cell may be interpreted as corresponding to the plane in which the one or more solar cells in the respective unit cell is/are arranged. The different extension planes may be parallel to each other. Due to such arrangement in different planes, the unit cells may overlap each other in a shingling manner. Therein, the tiling distance may correspond to a typical distance of the virtual tiles overlapping each other. This tiling distance may be measured in a direction orthogonal to the surface of the unit cells and may typically be in a similar range as the thickness of the unit cells or of conventional tiles i.e. in a range of typically between 3 mm and 30 mm, preferably between 5 mm and 20 mm.

According to an embodiment, the PV panel has a non-rectangular contour. In other words, while conventional PV panels typically have a rectangular contour, the PV panels proposed herein may deviate from such conventional design. For example, the PV panel may have non-linear lateral edges including laterally protruding portions and recessed portions. Particularly, the contour of the PV panel may be adapted such that neighbouring PV panels may engage with each other due to their abutting and cooperating non-linear edges.

According to a further specified embodiment, a first side edge of the panel may have a first non-linear contour and a second side edge of the panel opposite to the first side edge may have a second non-linear contour being complementary to the first non-linear contour. Therein, protruding portions at the first side edge may have a substantially same geometry or contour as recessed portions at the second side edge, and vice versa. Due to such complementary contours, neighbouring panels may locally engage with each other at their first and second edges. As a result, an interlaced or nested arrangement of multiple panels adjacent to each other may be generated such as to form an entire (roof) surface having a continuous, aesthetic appearance.

According to an embodiment, the PV panel may further comprise one or more connection boxes each including at least two electric contacts being accessible from outside the photovoltaic panel. Therein, multiple or all solar cells of the solar cell arrangement are electrically interconnected and the solar cell arrangement is electrically connected to the electric contacts of the one or more connection boxes. In other words, the multiplicity of solar cells comprised in the PV panel may all be interconnected with each other for generating one or a few PV strings of solar cells being electrically connected in series and/or in parallel and the entire solar cell arrangement prepared thereby may be electrically connected to the electric contacts in a single connection box (or alternatively to electric contacts in a few connection boxes such as two or three connection boxes per PV panel). In contrast hereto, in an approach in which multiple conventional PV tiles are used for electricity generation on a roof, each PV tile needs its own connection box. Accordingly, in the latter case, a number of required connection boxes corresponds to a number of PV tiles, thereby not only adding significant costs to the overall PV array due to the large number of required connection boxes but also adding to a required effort for installing the PV array due to all these connection boxes having to be electrically interconnected with each other. In other words, while, similar to conventional PV tiles, the PV panel proposed herein may provide for a visual appearance imitating conventional tiles, a number of connection boxes to be provided for imitating a large number of tiles may be significantly smaller than in the case of conventional PV tiles. In fact, such number of required connection boxes may be similar or same as in a case in which a roof is covered with large sized conventional PV panels.

According to a further specified embodiment, the connection box comprises a housing which comprises or mainly or completely consists of a moldable polymer and is formed integrally with portions of the support structure. Expressed differently, it is proposed that the connection box of a PV panel is formed as an integral portion or component together with the support structure.

Therein, both the support structure and the connection box may be made from a polymer, i.e. from a same polymer or from compatible polymers. Preferably, the support structure and the connection box may be prepared in a common manufacturing step. For example, both parts may be prepared in a same mold using injection molding techniques. As a result, various benefits such as reduced production costs, increased reliability, simplified interconnection, etc. may be achieved.

It shall be noted that possible features and advantages of embodiments of the invention are described herein mainly with respect to a novel type of a building-integrated PV panel, wherein some aspects are described with respect to a method which may be used for producing such PV panel. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows a cross-section of a PV panel in accordance with an embodiment of the present invention.
Fig. 2 shows a top view onto a PV panel in accordance with an embodiment of the present invention.

The figures are only schematic and not to scale. Same reference signs refer to same or similar features.

### DESCRIPTION OF PREFERRED EMBODIMENTS

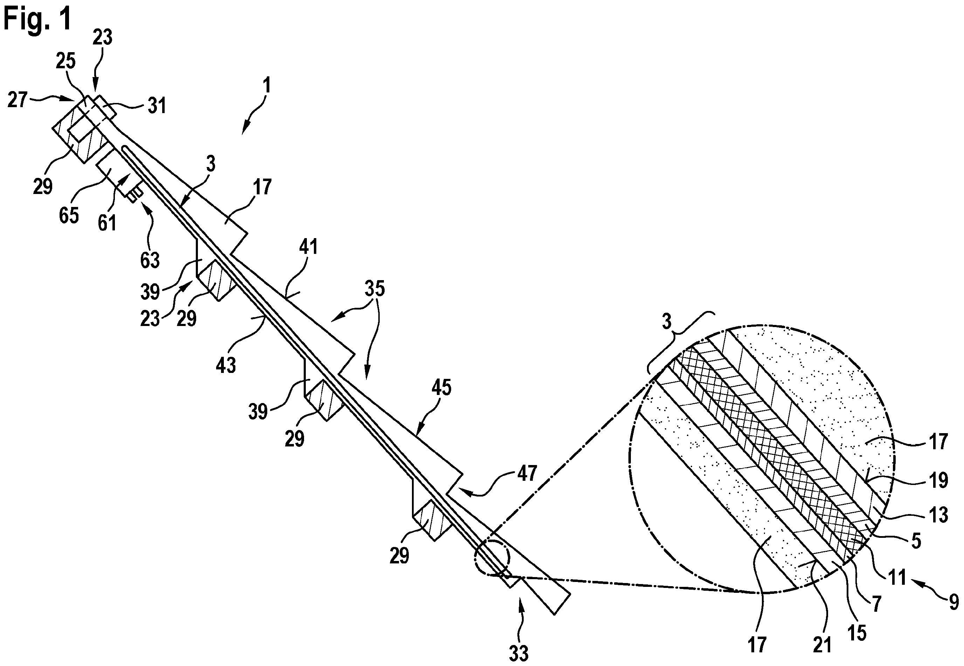

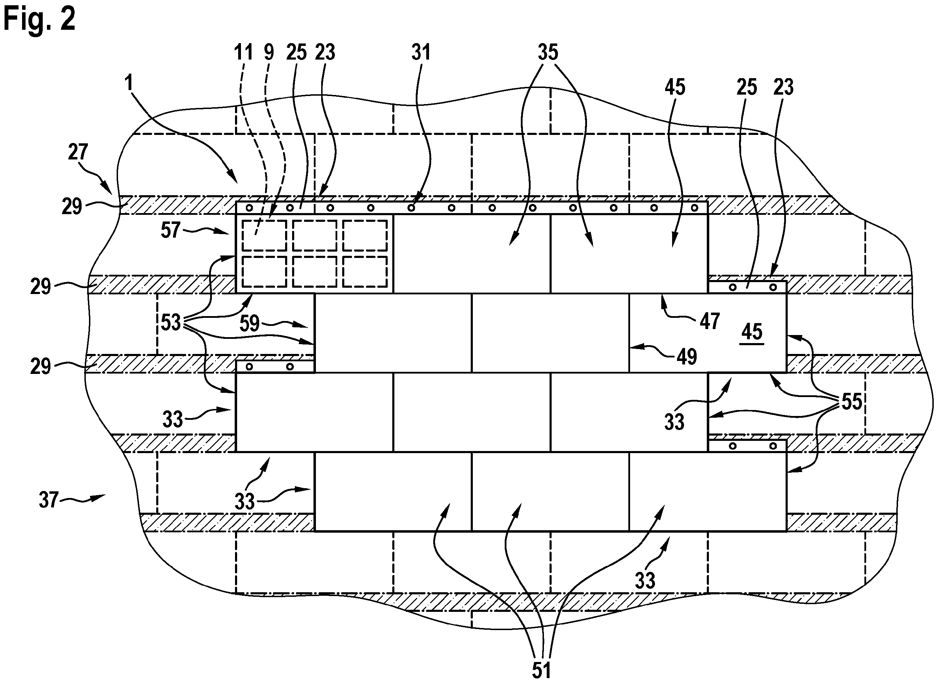

Fig. 1 shows a cross-sectional view of a PV panel 1 installed on a carrier structure 27 of a building. Fig. 2 shows a top view onto the PV panel 1 being part of an entire PV array 37.

The PV panel 1 comprises a PV label 3 embedded in a support structure 17. The PV label 3 comprises a solar cell arrangement 9 including multiple solar cells 11 which are interposed between a front side polymeric lamination foil 5 and a rear side polymeric lamination foil 7 forming an encapsulation for the solar cell arrangement 9. Preferably, the solar cells 11 are a high efficiency wafer-based silicon solar cells. Even more preferably, the solar cells 11 are back contact solar cells, such as IBC solar cells, having all their electrical contacts on a rear side of a solar cell substrate. Furthermore, the solar cell arrangement 9 comprises electrical interconnectors (not shown) for electrically interconnecting the solar cells 11 in series and/or in parallel. In a beneficial implementation in which the solar cells 11 are back contact solar cells, such electrical connectors may be implemented e.g. using a patterned metal structure deposited on a foil, wherein such foil may be the rear side polymeric lamination foil 7 or an additional foil to be combined or laminated together with the lamination foils 5, 7. The solar cell arrangement 9 may comprise further components such as bypass diodes, etc. (not shown).

In the example shown, the PV label 3 further comprises a front side polymeric stabilisation foil 13 and a rear side polymeric stabilisation foil 15. Such stabilisation foils 13, 15 are generally thicker than the lamination foils 5, 7 and/or consist of a polymer material having a larger mechanical strength than the material of the lamination foils 5, 7. Accordingly, such stabilisation foils 13, 15 may increase a mechanical rigidity and/or load-bearing capacity of the PV label 3, such as to prevent for example the solar cells 11 from being excessively bent or mechanically locally loaded e.g. during a manufacturing procedure. Optional characteristics of the lamination foils 5, 7, the stabilisation foils 13, 15 and the solar cell arrangement 9 are also described in the applicant's prior patent applications.

In order to mechanically stabilise the PV label 3 and, particularly, protect the PV label 3 against environmental influences such as rain, wind, hail, etc., the PV panel 1 comprises a support structure 17. The support structure 17 mainly or completely consists of a mouldable polymer. Optionally, a combination of two or more polymers may be comprised in the support structure 17 and/or the polymer material may be reinforced using fibres such as glass fibres, carbon fibres, etc. The polymer may have a high transparency such that e.g. more than 90%, preferably more than 95% or 98% of incident light is transmitted through a layer of the polymer with a thickness of 5 mm. The support structure 17 covers at least a front surface 19 of the PV label 3. Preferably and as shown in the example of Fig. 1, the support structure 17 also covers a rear surface 21 of the PV label 3, thereby embedding the entire PV label 3 in the polymer forming the support structure 17.

Such support structure 17 may be made by injection moulding techniques. Particularly, the prefabricated PV label 3 may be included in a mould having an intended shape of the PV panel 1 and mouldable polymer may then be injected into the mould for forming the support structure 17. Due to the use of such injection moulding technique, the PV panel 1 with its support structure 17 may be formed into complex, non-planar geometries.

The support structure 17 may be made such that a portion of the support structure 17 covering the front surface 19 of the PV label 3 forms a layer having a sufficient thickness for providing weather resistance, particularly rain and hail resistance, to the underlying PV label 3. For example, such polymer layer of the support structure 17 may be thicker than 2 mm, preferably thicker than 5 mm. Due to such thick polymeric support structure 17 on top of its front surface 19, the PV label 3 and particularly its solar cells 11 are well protected against weather influences. Accordingly, the provision of a glass front sheet as conventionally used in PV panels is generally dispensable, thereby reducing e.g. costs, manufacturing energy consumption and/or weight of the PV panel 1. In other words, the polymeric support structure 17 may form an outermost and exposed front surface of the PV panel 1.

The support structure 17 further comprises a fixation arrangement 23. Such fixation arrangement 23 includes multiple attachment structures 25 which are configured such that the PV panel 1 with its support structure 17 may be attached to a carrier structure 27 provided at a surface of a building. For example, such carrier structure 27 may comprise multiple rafters 29 fixed to roof beams (not shown) at the building's roof. In the simple implementation shown in the figures, the attachment structures 25 are formed by a lateral extension of the support structure 17, the lateral extension including through-holes through which fixation elements 31 such as screws may extend. Additionally, the fixation arrangement 23 may further comprise retainer protrusions 39 protruding for example at a rear side of the PV panel 1, such retainer protrusions 39 serving for example for retaining the PV panel 1 at other rafters 29. It is to be noted that those skilled in the art know that various other types of attachment structures 25 may be used for implementing a fixation arrangement 23 for the PV panel 1.

Preferably, the attachment structures 25 and/or the retainer protrusions 39 may be made with a mouldable polymer. For example, the attachment structures 25 and/or the retainer protrusions 39 may be made with the same polymer as used for other portions of the support structure 17. Accordingly, the attachment structures 25 may preferably be made in a same injection moulding process as used for forming the support structure 17 and may therefore integrally protrude from other portions of the support structure 17.

The PV panel 1 with its support structure 17 and its fixation arrangement 23 is specifically configured such that the support structures 17 of neighbouring PV panels 1 may be attached to the building's carrier structure 27 in a manner such as to partially overlap each other in a shingling manner. For such purpose, the support structure 17 of the PV panel 1 may be prepared with a geometry such that, on the one hand, portions of the support structure 17 forming the fixation arrangement 23 are arranged and configured such that the support structure 17 may be attached to the building's a carrier structure 27, while, on the other hand, other portions of the support structure 17 are configured such as to overlap portions of a neighbouring PV panel 1. For example, the latter mentioned other portions may be formed by an sealing structure 33. The sealing structure 33 may be formed e.g. by a undercutting or overcutting portion of the support structure or by any other geometrical and/or material feature providing for sealing effects e.g. between neighboring PV panels. Such sealing structure 33 may be arranged at one or plural lateral edges of the PV panel 1, particularly at edges of the PV panel 1 being directed horizontally or downwardly upon the PV panel 1 being installed on the building. The sealing structure 33 may be configured such as to locally overlap portions of the support structure 17 of a neighbouring PV panel 1, the sealing structure 33 and the overlapped portions preferably having complementary geometries, similar to for example a tongue and groove configuration.

As visualised in Fig. 1, the support structure 17 is provided with a non-flat surface geometry. Particularly, a front surface 41 of the PV panel 1 is provided with a step geometry. In such step geometry, a sloped front surface portion 45 is arranged at an acute angle of between 2° and 20° relative to a rear surface 43 of the PV panel 1. The PV panel 1 comprises multiple such sloped front surface portions 45 arranged in horizontal rows. Therein, neighbouring sloped front surface portions 45 are connected to each other via a flank front surface portion 47. Such flank front surface portion 47 extends almost orthogonal, i.e. for example with an angle in a range of between 70° and 110°, relative to the rear surface 43 of the support structure 17. Accordingly, each sloped front surface portion 45 is delimited with regards to a sloped front surface portion 45 neighbouring in a vertical direction by an intermediate flank front surface portion 47.

Furthermore, as visualised in Fig. 2, sloped front surface portions 45 neighbouring each other in a horizontal direction are delimited from each other by a vertical groove 49.

With such non-flat surface geometry, the support structure 17 may imitate multiple virtual tiles 35. Therein, each sloped front surface portion 45 and its associated flank front surface portion 47 and groove 49 may be interpreted as a unit cell 51 representing one virtual tile 35. Each virtual tile 35 has a size similar to conventional tiles. Therein, the virtual tile 35 comprises multiple solar cells 11 in the PV label 3 included in its unit cell 51 (wherein it is to be noted that, for simplified visualisation, solar cells 11 are only shown in the uppermost left virtual tile 35 in Fig. 2).

In the example shown in the figures, each unit cell 51 has a planar surface and a rectangular contour. However, it is to be noted that using for example the injection moulding technique for preparing the support structure 17, each unit cell may have a curved surface and/or a curved contour. Therein, the curved surface may comprise macroscopic curved portions, thereby influencing for example its visual appearance and/or its water draining characteristics. Additionally or alternatively, the curved surface may comprise microscopic curved portions, e.g. for generating dirt repellent characteristics (Lotus effect). Furthermore, the unit cells 51 may have a rounded contour, e.g. for imitating conventional rounded shingles.

As a further option, the front side surface of the support structure may be provided with a texture similar to a roughened surface structure, thereby reducing e.g. direct reflexion of incident light. In other words, using the options available due to the injection moulding technique being useable for fabricating the solar panel described herein, the front side surface of the panel may easily be provided with an uneven structure. Accordingly, in contrast to conventional solar panels which generally have a planar glass sheet at its front side and which may therefore produce intense reflexions being completely directed in one direction thereby disturbing e.g. neighbours of a building with BiPV, the PV panels described herein may produce more diffuse and therefore less disturbing reflexions.

Furthermore, in order to imitate the visual appearance of a conventional shingled roof, vertically neighbouring unit cells 51 extend along planes being spaced from each other by a tiling distance. In other words, the sloped front surface portions 45 of virtual tiles 35 in different rows of tiles extend in parallel planes, wherein a distance between such planes corresponds to the tiling distance and is substantially defined by a width of the flank front surface portion 47 extending between the neighbouring sloped front surface portions 45.

As visualised in Fig. 2, the PV panel 1 has a non-rectangular contour. Particularly, a first side edge 53 of the panel 1 comprises laterally protruding portions 57 and the laterally recessed portions 59. Such protruding and recessed portions 57, 59 may have sizes resulting from dimensions of the unit cells 51 forming the virtual tiles 35 and/or from a pitch distance in a horizontal and/or vertical direction between neighbouring unit cells 51. A second side edge 55 opposing the first side edge 53 of the panel 1 comprises a non-linear contour being complementary to the contour at the first side edge 53. Due to such complementary contours, neighbouring PV panels 1 may be arranged such as to laterally engage with each other in a nested manner, thereby improving a mechanical interconnection between the neighbouring PV panels 1 and increasing an overall stability of the entire PV array 37. Furthermore, for example a side edge and/or a lower edge portion at each of the laterally protruding portions 57 and/or a side edge of the recessed portion 59 may be provided with an sealing structure 33 such as to locally overlap an adjacent side edge or upper edge portion, respectively, of a laterally protruding portion 57 and/or a laterally recessed portion 59 of a neighbouring PV panel 1.

As visualised in Fig. 2, the PV panel 1 may have a substantial size of more than 0.5 m² and includes a multiplicity of solar cells 11 (72 solar cells in the represented example), such as to provide the solar cell arrangement 9 with a peak power capacity of typically more than 200 Wp. Accordingly, the PV panel 1 has similar dimensions and a similar peak power capacity as conventional PV panels. This enables the proposed PV panels 1 to be operated using for example conventional converters, conventional MPPT, etc. Furthermore, the large-sized PV panels 1 may be rapidly installed at a building, as each PV panel 1 covers a substantial area and therefore only a relatively small number of PV panels 1 is to be installed (in contrast to a case where for example a roof is to be covered with a large multiplicity of small PV tiles).

Furthermore, providing the PV panel 1 with a large size and large peak power capacity may help reducing wiring efforts for electrically interconnecting the PV panels 1 in the PV array 37. For such purpose, each PV panel 1 comprises one or more connection boxes 61. The connection box 61 includes electric contacts 63 accessible from outside the PV panel 1. The solar cells 11 in the solar cell arrangement 9 are electrically interconnected and connected to the electric contacts 63, thereby enabling electrically interconnecting neighbouring PV panels 1 and electrically connecting the entire PV array 37 to a converter or an electricity consumer. The connection box 61 comprises a housing 65 accommodating the electric contacts 63. Such housing 65 may be made with a mouldable polymer. Accordingly, the housing 65 may be integrally formed together with other portions of the support structure 17.

Summarising, the PV panel 1 proposed herein differs from conventional PV panels and from conventional PV tiles in that its solar cells 11 are comprised in a PV label 3 and the PV label 3 is mechanically stabilised by a support structure 17, wherein the support structure 17 generally does not comprise any glass front sheet but covers the front surface of the PV label 3 with a thick layer of polymer. Particularly, the support structure 17 is preferably moulded onto the PV label 3 by injection moulding techniques. Therein, the PV panel 1 has similar dimensions and peak power capacity as conventional PV panels and therefore differs from small sized conventional PV tiles. However, in contrast to conventional PV panels, the PV panel 1 proposed herein is specifically adapted for being directly attached to a building's carrier structure 27. F, wherein neighbouring PV panels 1 are configured for laterally overlapping each other in a shingling manner. The proposed PV panel 1 may provide for various advantages in comparison to conventional building-applied PV using conventional PV panels or using conventional PV tiles such as:
- reduced costs, as no separate conventional tiles and additional PV panels are to be provided or, alternatively, as no multiplicity of conventional PV tiles is to be provided and electrically interconnected; lower number of connection boxes required as compared to one connection box for each of a large multiplicity of conventional PV tiles;
- simplified cabling, as a small number of PV panels needs to be interconnected; less efforts and less costs for cables;
- standard converters and MPPT may be used;
- good longevity as e.g. the polymeric support structure does generally not break in case of a hailstorm (enabling less replacement costs, better insurance, etc.)
- improved aesthetics due to integration of the PV directly into the roof (no separate PV panels) and possible adaption of the visual appearance of the PV panel to imitate conventional tiles;
- improved sustainability as polymer-based support structure of the PV panel may be produced with less energy (compared to conventional PV panels comprising glass cover sheets) and may possibly be recycled (using, inter-alia, the different melting temperatures of the materials comprised in the PV panel with the polymer having a substantially lower melting point than e.g. metals forming the electric contacts and silicon forming the solar cells);

As an additional remark, it shall be noted that, using the applicant's novel injection moulding manufacturing technique, additional beneficial features may be implemented for the PV panel.

For example, additional components or devices may be included in the PV panel and may for example be embedded in the polymer forming the support structure. For example, light emitters such as LEDs may be integrally embedded in the PV panel, thereby allowing for example illuminating portions of the PV panel for giving them an intended colour or even generating light effects which may be used for example for advertising purposes. Alternatively or additionally, sensors may be integrally embedded in the PV panel, allowing for example integrated temperature measurement capabilities, mechanical strain supervision in the PV panels, etc. Furthermore, the PV panels may be provided with different colours. While the solar cells should generally be as dark as possible (e.g. black or dark blue) in order to optimise their efficiency, solar cells may also be provided with other colours (e.g. red, blue, green, etc.) in cases where a visual appearance of the PV panel shall be modified. For example, PV panels imitating conventional red-coloured tiles may be prepared using solar cells having a reddish front surface due to e.g. their antireflection coating being specifically adopted for reflecting red spectrum portions. Optionally, a colour of the PV panel at gaps between neighbouring solar cells may be adapted to the colour of the solar cell, e.g. by using coloured rear surface polymeric foils in the PV label, thereby providing the PV panel with a homogeneous colour appearance.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV panel
- 3: PV label
- 5: front side polymeric lamination foil
- 7: rear side polymeric lamination foil
- 9: solar cell arrangement
- 11: solar cell
- 13: front side polymeric stabilisation foil
- 15: rear side polymeric stabilisation foil
- 17: support structure
- 19: front surface of PV label
- 21: rear surface of PV label
- 23: fixation arrangement
- 25: attachment structure
- 27: building's carrier structure
- 29: rafter
- 31: screw
- 33: sealing structure
- 35: virtual tile
- 37: PV array
- 39: retainer protrusion
- 41: front surface of PV panel
- 43: rear surface of PV panel
- 45: sloped front surface portion
- 47: flank front surface portion
- 49: groove
- 51: unit cell
- 53: first side edge of the panel
- 55: second side edge of the panel
- 57: laterally protruding portion
- 59: laterally recessed portion
- 61: connection box
- 63: electric contacts
- 65: housing

## Claims

1. Photovoltaic panel (1) for an installation on a building, the panel including:
a photovoltaic label (3) comprising a front side polymeric lamination foil (5), a rear side polymeric lamination foil (7) and a solar cell arrangement (9) including multiple solar cells (11) interposed between the front and rear side lamination foils (5, 7);
a support structure (17) supporting the photovoltaic label (3), wherein the support structure (17) comprises a mouldable polymer covering at least a front surface (19) of the photovoltaic label (3);
wherein the support structure (17) comprises a fixation arrangement (23) including multiple attachment structures (25) configured for being attached to a carrier structure (27) provided at a surface of the building;
wherein the support structure (17) is configured such that support structures (17) of neighbouring photovoltaic panels (1) are attachable to the building's carrier structure (27) such that the neighbouring photovoltaic panels (1) overlap each other in a shingling manner.

2. Photovoltaic panel (1) according to claim 1,
wherein the support structure (17) is made by injection moulding the mouldable polymer together with the photovoltaic label (3).

3. Photovoltaic panel (1) according to one of the preceding claims,
wherein the support structure (17) covers the front surface (19) of the photovoltaic label (3) with a polymer layer having a thickness of at least 2 mm.

4. Photovoltaic panel (1) according to one of the preceding claims,
wherein the attachment structures (25) comprise a mouldable polymer and integrally protrude from other portions of the support structure (17).

5. Photovoltaic panel (1) according to one of the preceding claims,
wherein the PV panel (1) comprises an area of at least 0.3 m² and/or
wherein the solar cell arrangement (9) has a peak power capacity of at least 100 Wp.

6. Photovoltaic panel (1) according to one of the preceding claims,
wherein the support structure (17) is provided with a non-flat surface geometry.

7. Photovoltaic panel (1) according to one of the preceding claims,
wherein the support structure (17) is provided with a surface geometry imitating multiple tiles (35).

8. Photovoltaic panel (1) according to one of the preceding claims,
wherein the support structure (17) is provided with a surface geometry being composed of multiple identical unit cells (51).

9. Photovoltaic panel (1) according to claim 8,
wherein each unit cell (51) has a curved surface and/or a curved contour.

10. Photovoltaic panel (1) according to one of claims 8 and 9,
wherein neighbouring unit cells (51) extend along planes being spaced from each other by a tiling distance.

11. Photovoltaic panel (1) according to one of the preceding claims,
wherein the PV panel (1) has a non-rectangular contour.

12. Photovoltaic panel (1) according to claim 11,
wherein a first side edge (53) of the PV panel (1) has a first non-linear contour and a second side edge (53) of the PV panel (1) opposite to the first side edge (53) has a second non-linear contour being complementary to the first non-linear contour.

13. Photovoltaic panel (1) according to one of the preceding claims,
further comprising one or more connection boxes (61) each including at least two electric contacts (63) being accessible from outside the PV panel (1),
wherein multiple or all solar cells (11) of the solar cell arrangement (9) are electrically interconnected and the solar cell arrangement (9) is electrically connected to the electric contacts (63) of the one or more connection boxes (61).

14. Photovoltaic panel (1) according to claim 13,
wherein the connection box (61) comprises a housing (65) which comprises a mouldable polymer and is formed integrally with portions of the support structure (17).
